# EUROPEAN PATENT APPLICATION

(11) **EP 1 207 734 A1**
(43) Date of publication of application: **22.05.2002**
(21) Application number: 00610117.4
(22) Date of filing: 20.11.2000
(51) Int. Cl.: H05K 9/00

(54) **Method of manufacturing items with bend projections**

(71) Applicant: LK Engineering A/S, 2100 Copenhagen (DK)
(72) Inventor: Traberg, Lars, 2100 Copenhagen Ö (DK)
(74) Representative: Kristoffersen, Bo

(57) **Abstract**

The present invention relates to a method of providing an item, comprising a bend member projecting from a body, at a mounting/placing location, especially the invention relates to a method of providing and mounting/placing an EMC gasket having spring members. According to the invention sheet-like members are packed and shipped in their non-bend stage from a first location after which they are unpacked and bend at a second location after which they are placed or mounted. By this method sheet-like members comprising bend projections can be provided at a given location in a cost-effective manner.

## Description

### FIELD OF THE INVENTION

The present invention relates in its broadest concept to a method of providing an item comprising a bend member projecting from a body. More specifically the present invention relates to a method of supplying such an item at a mounting/placing location, and most specifically the present invention relates to a method of providing and mounting/placing an EMC gasket having spring members.

### BACKGROUND OF THE INVENTION

Electromagnetic interference is a common and well-known problem associated with electronic equipment. Normal circuit operation creates electromagnetic waves which induce undesirable signals and interfere with the normal operation of other electrical components. These undesirable signals, termed electromagnetic or RF (radio frequency) interference, can be minimized by shielding portions of the circuit within a conductive shield at a low or ground potential. This grounded electromagnetic shield dissipates electrostatic build-up and absorbs the electromagnetic field thereby shielding the circuit from electromagnetic interference.

A typical field in which electromagnetic interference concerns are present is in the design of mobile phones. Depending on the actual design, it may be necessary to either shield specific components inside the apparatus itself against electromagnetic interference, in- or outgoing, or to shield the apparatus as such with a housing functioning as an overall shield.

In the past, it has been common practice to solder an electromagnetic shield to a ground trace formed on a printed circuit board of a radiotelephone. This approach obviously yields excellent conductive contact between the shield and the ground trace of the printed circuit board. However, soldering the electromagnetic shield to the printed circuit board makes inspection and repair of the printed circuit board practically impossible. It is highly desirable for the shield and printed circuit board to be of a design that readily accommodates inspection and repair.

Conductive gaskets can also be used as a conductive interface between an electromagnetic shield, either between a housing and the printed circuit or between two housing components, e.g. an upper and a lower housing for a mobile telephone.

Spring clips and fingers have been utilized in mobile phones for the purpose of maintaining conductive contact between an electromagnetic shield and a ground trace formed on a printed circuit board. See, for example, the disclosure of U.S. Pat. No. 5,053,924 in which contact-providing elastic clip members are mounted on a housing. Indeed, the mounted clip members add to the complexity, size and costs for the overall shielding device.

A more recent approach is disclosed in U.S. Pat. No. 5,748,455 which discloses an electromagnetic shield including a face and a sidewall extending around the face, and with a series of spaced apart, integrally formed spring contacts extending from the sidewall of the shield and making electrical contact with the ground trace of the printed circuit board.

As mentioned above, the electronics of, for example, a mobile phone can also be shielded by one or more conductive gaskets. For example when two or more housing parts are used to enclose the circuitry, a gasket is placed between the conductive housing parts in order to establish electrical contact between the parts which can be manufactured from either metal or metalized plastics. Such a gasket can also be used between an internal shield and a circuit board. In order to maintain conductive contact between the housing parts, the principle of spring contacts has also been utilized for the gaskets. For example, U.S. Pat. No. 5,039,825 discloses an arrangement in which a corrugated strip serves as a gasket, and where the force exerted by the corrugated strip provides electrical continuity between the conductive surfaces to be connected by the gasket.

A more recent gasket is disclosed in the brochure "EMC metal gaskets" published by LK Engineering as, DK-2100 Copenhagen, Denmark. The disclosed metal gasket consists of a rim-like frame adapted to follow the contour to be shielded, i.e. the contacting area between two components. To ensure contact the frame comprises a number of small contact springs, typically 1-1.5 mm in length integrated into the frame and bend out of the general plane of the gasket. As above, screening takes place by the springs creating electrical contact between, for example, the shield and the circuit board. To ensure low force of compression, the thickness of the springs is reduced in comparison to the frame portion of the gasket.

In general, the above-described types of gaskets may be very thin, typically 0.15 mm and comprising a large number of very small springs. Further, the gasket portions carrying the springs may have dimensions (for example a width) which is in the same range as the springs, correspondingly, such delicate sheet-like gaskets have to be handled with great care during the subsequent handling, packaging, shipping and mounting procedures as it is evident that they cannot be handled in bulk and that simply stacking the gaskets would result in the gaskets sticking to each other due to the large number of tiny projecting members. Correspondingly, the finished gasket has traditionally been supplied to the customer as individually packed units, either in boxes sandwiched between layers of silk-paper which then have to be unpacked manually, on mounting tape or in trays for SMD assembly, or mounted on shields. It follows from this that the combined cost of packaging and shipping of this type of gasket over large distances is relatively costly. Especially it is a problem that reuse of the packaging is cost ineffective due to the bulkiness of the packaging, e.g. the SMD tray, and the great distances.

It is therefore an object of the present invention to provide a method in which sheet-like members comprising bend projections can be provided at a given location in a cost-effective manner. More specifically, it is an object to provide an efficient method in which metal gaskets can be provided at a location closer to the actual site of mounting of the gasket. Apart from the cost-savings in the initial shipping, this would make reuse of the packaging material possible as well as the shorter distance between the bending facility and the mounting facility would necessitate a smaller number of, for example, SMD trays to be circulated between the bending, placing and mounting facility.

Other objects and advantages of the present invention will become apparent and obvious from a study of the following description and the accompanying drawings, which are merely illustrative of the present invention.

### SUMMARY OF THE INVENTION

The present invention is based on the realization that the sheet-like members should be packed and subsequently shipped or transported in an unfinished form and that the finishing steps of manufacture should be carried out after un-packing the unfinished members at a location closer to the desired location of use of the finished product.

According to the present invention this implies that the sheet-like members are packed and shipped in their non-bend stage at a first location after which they are unpacked and bend at a second location. The non-bend member is traditionally termed a blank which term will be used throughout this application whereas the bend member is termed a processed blank. The processed blank may either be in the form of an individual, processed blank thus representing the finished product or as a member comprising a number of processed blanks.

The term "packaging" defines that the sheet-like members after manufacturing are arranged in a convenient way suitable for transport or shipping, e.g. stacking or rolling. In a more specific sense the term packing includes that the members are enclosed in a suitable enclosure such as a box, container or the like providing protection against external influences during handling and shipping. The term "shipping" defines that the packed sheet-like members are transferred to a different, external facility, e.g. from an etching or stamping facility to a mobile phone assembling facility. In a more specific sense shipping could be defined as transporting in "open air" (indeed protected in some suitable enclosure or carrier) in order to distinguish from mere inside factory transportation between different workstations.

After manufacture the blanks may be arranged in any suitable way allowing ease of transportation, compact packaging and good protection against damage from the outside. As will be described below in greater detail, blanks for, for example, metal gaskets are manufactured in individual large sheets or "endless" sheets, the sheets normally comprising a number of blanks across the width thereof, each surrounded by a rim of material attached by a number of bridge portions which are later removed but at this stage serves to protect the edges of the blanks. If the blank is in the form of a rim-like member an "internal" portion could also be connected with a number of bridges. The packaging may be in the form of stacks of individual sheets or a coil of an endless sheet. In order to provide a convenient basis for the subsequent bending process, the sheets may be split longitudinally before packaging resulting in sheets comprising only one or a few members across the width thereof. If the sheets are manufactured individually, an endless sheet can be provided by attaching sheets or portions thereof to each other. In order to avoid that the fine structures of the blank engage each other, the individual sheets or layers in the role should be separated by a suitable dividing material such as paper or a foil.

At the desired "end"-destination for the packed blanks, they are introduced to the bending means resulting in finished members, for example, metal gaskets having bend springs. The above-described portions may be cut off before, during or after the bending procedure. The finished gaskets may be supplied to the subsequent procedures as "biscuits" comprising a number of blanks typically arranged on a string for better handling. Preferably the above procedures are fully automated, such that unpacking, feeding of the blanks to the bending and cutting tools, transport of the finished members to the placing or mounting facility require no manual handling. For this purpose coiling of the blanks in endless sheets are preferred.

According to a further aspect of the invention, a system is disclosed for providing a member comprising at least one bend extension projecting from a base member, the system comprising: means for supporting a continuous length of a sheet-like member comprising a plurality of blanks, each blank comprising a base member with a plurality of extensions projecting in the plane of the base member, means for uncoiling at least a portion of the sheet-like member from the coil, means for bending at least one extension projecting from the base of the blank in order to provide a processed blank, and means for introducing the blank into the bending means, the system thereby allowing unpacking of the blank members, feeding of the blanks to the bending and cutting tools, transport of the finished members to a mounting or placing facility for the final processing thereof.

Other objects and advantages of the present invention will become apparent and obvious from a study of the following description and the accompanying drawings, which are merely illustrative of such invention.

### BRIEF DESCRIPTION OF THE DRAWINGS

Figs. 1A-1I show the different stages in manufacturing a gasket blank using chemical milling,
fig. 2 shows (in partial) an actual embodiment of an EMC metal gasket which advantageously could be manufactured using the method of the present invention,
fig. 3A shows a first embodiment of bending facility for the manufacturing of bend items,
fig. 3B shows a section along line A-A in fig. 3A,
fig. 4A shows a second embodiment of bending facility for the manufacturing of bend items, and
fig. 4B shows a section along line B-B in fig. 4A, the non-sectioned portions not being shown.

### DETAILED DESCRIPTION OF THE INVENTION

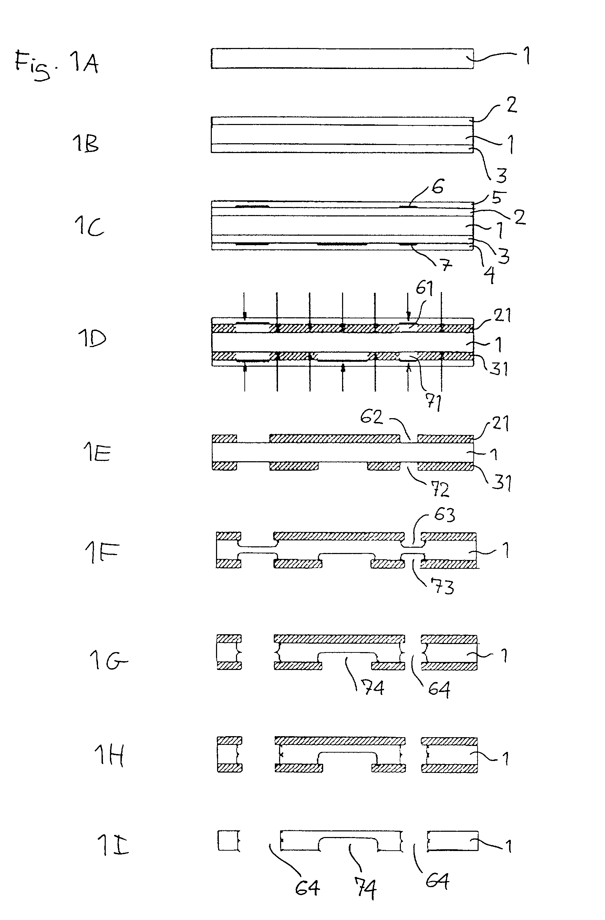

With reference to the Figs. 1A-1I a preferred method for manufacturing a gasket to be shipped and bend in accordance with the present invention will be described, i.e. a method for manufacturing a gasket comprising a number of finger-like extension having a reduced thickness, in the following called a blank. The described steps of manufacturing such a blank is not part of the present invention but is only provided to more fully appreciate the present invention.

The illustrated method is normally known as chemical milling and is based on the principle that portions of a metal member, often a sheet-like member, are removed by etching from the surface of the member. Apertured masks for colour televisions are a well-known product manufactured by this technique.

In large-scale production an endless metal sheet (also called web) for a large number of items is passed through a number of stations in which the different steps are performed. Fig. 1A shows the metal web 1 which for an EMC gasket may be 0.15 mm tempered stainless steel (1800 N/mm²) which after having been cleaned subsequently is covered with a coating 2, 3 on respective sides, see Fig. 1B. Thereafter masking foils 5, 4 with the pattern 6 to be etched on the respective sides of the web are placed on top of the coating layer, see Fig. 1C. The web is then exposed to, for example, UV light (see Fig. 1D) and subsequently developed such that the exposed coating forms an etchant resist coating 21, 31 with the non-exposed areas 61, 71 of the coating being removed to leave the metal web unprotected at 62, 72 corresponding to the pattern of the mask, see Fig. 1E. It is these portions of the metal web which are to be etched during the subsequent etching procedures.

Thereafter the web is passed through one or more etching stations (not shown) wherein a plurality of upper and lower etchant spray nozzles are arranged to allow the etchant spray to be dispersed over a wide area. Fig. 1F shows that the unprotected areas 63, 73 are partly etched and Figs. 1G and 1H show that openings 64 are formed whereas the portions of the web with resist coating on only one side have given rise to areas 74 with reduced thickness. Fig. 1I shows the finished web with the resist coating removed.

The manufacturing method described with respect to Figs. 1A-1I illustrates the principle of chemical milling. The projections to be bend may be formed as portions 74 with reduced thickness for greater ease of bending as described in Applicants co-pending application and as described below.

As mentioned above, a large number of items, e.g. blanks, are formed on the web, the individual blanks being connected to each other by a number of "external" bridges. If the blank is in the form of a rim-like member the "internal" portion is also connected with a number of bridges.

After etching the web is cleaned and, optionally, split to provide a sheet having a desired width. Hereafter the endless sheet is provided with a layer of protective sheet material which together are coiled to form a coil with intermittent layers of the sheet and the protective material. Finally the coils having any desired length are provided with a protective outer casing where after they are ready to be shipped to their "final" destination for bending and mounting.

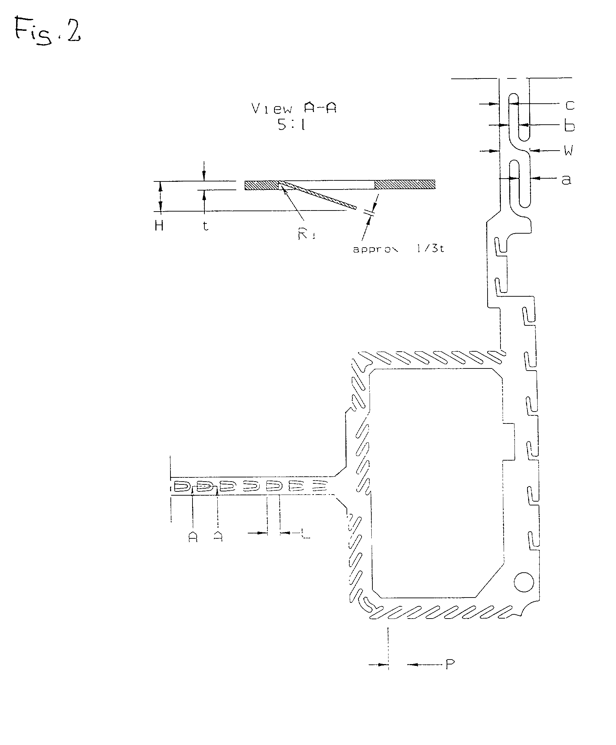

Fig. 2 shows (in partial) an actual embodiment of an EMC metal gasket which advantageously could be manufactured using the method of the present invention. As can be seen the gasket is made up of rim-like portions which in combination form one or more closed rim-portions of which one is shown. The following values given are only illustrative for this application and can be chosen according the desired application. Material example: 0.15 mm (= t) hardened stainless steel; bending radius Ri = 4-5t, width of frame W = 0.80 mm, length of springs L = typically 1-1.5 mm, height of springs H = typically 0.3-1.0 mm, minimum pitch between springs P = 1.2 mm; a not less than 0.30 mm, b not less than 0.25 mm and c not less than 0.25 mm.

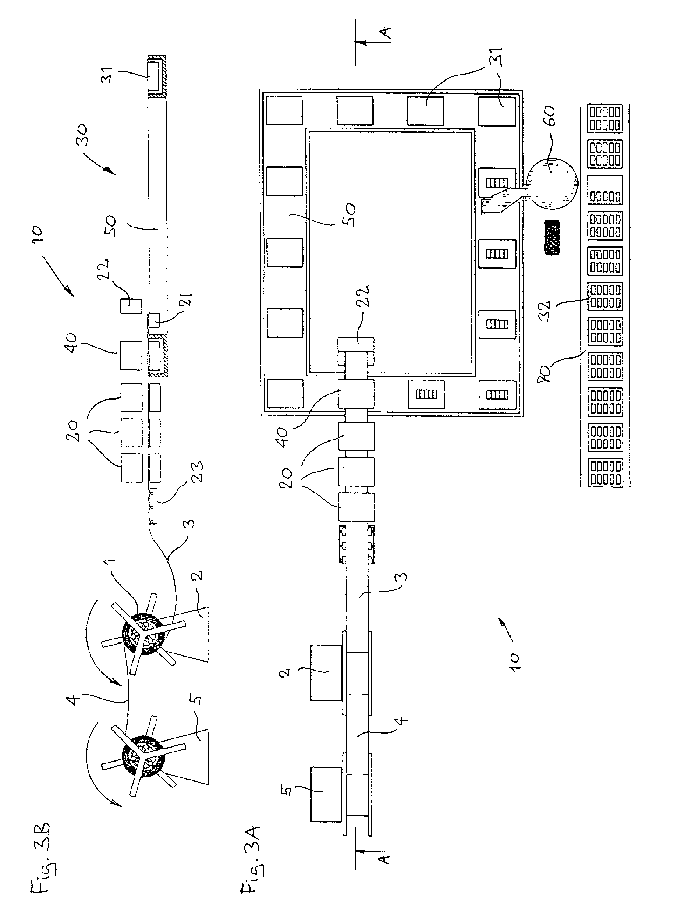

Next the bending and placing procedures will be described with reference to figs. 3A and 3B showing a bending and placing line for the product-on of, for example, gaskets for mobile phones.

When a coil 1 arrives it is unpacked and arranged in a rack 2. When unwinding the coil, the blank sheet 3 is fed to a manufacturing line 10 and the protective sheet 4 is coiled on a rack 5 for subsequent disposal or reuse. The manufacturing line comprises a number of cutting and bending stations 20, an assembly line 30 for placing or mounting of the gaskets and a gasket placing or mounting station 40. In the illustrated embodiment three stations are provided for the cutting and bending procedures, however, these procedures can be conducted by any given number of stations in any given order providing the necessary functions, i.e. cutting the above-described bridges in order to free the gasket for the rim and internal portions and bending the desired portions of the blanks. Cut off portions of the sheet member are collected in containers 21. The sheet may conveniently be supported on rollers 23 prior to processing and pulled through the bending and cutting stations by drive means 22. The finished members, for example metal gaskets, are supplied to the placing or mounting station 40 either individually or as biscuits in which case the individual gaskets may be cut from the connecting bridge portion during a mounting procedure.

The shown assembly line comprises a general-purpose transportation facility in the form of a four sided conveyor line arrangement 50 allowing items to be positioned relative to a number of mounting or placing stations or facilities (not shown). A number of fixtures or pallets 31 are transported on the conveyer line 50 through a number of positions in a circulating manner. In the illustrated embodiment 14 fixtures are shown (one covered by the mounting station 40) representing 14 positions on the conveyer line. For each position a mounting station which can be either automated or manually operated may be arranged, however, in the shown embodiment only two mounting stations are used. In a first placing or mounting station 40 the gaskets are placed as five individual gaskets in intermediate transport fixtures in order to bring the gasket to, for example, an assembly station where the five gasket are placed on five respective shield members after which the fixtures 31 are conveyed back to the gasket placing station. The placing may either be performed by an operator or by a pick-and-place robot 60 resulting in five individual gaskets being placed on five respective shield members carried in fixtures 32 transported on a second conveyer line 70. Such shield members are used as internal housing components for mobile phones, in which electronic circuitry is later mounted. It would also be possible to place shield-carrying fixtures on the conveyer line such that mounting of the gaskets would take place at the station 40 which would then save the above-described intermediate step but would necessitate that the shields are placed and subsequently removed from the conveyer line 50.

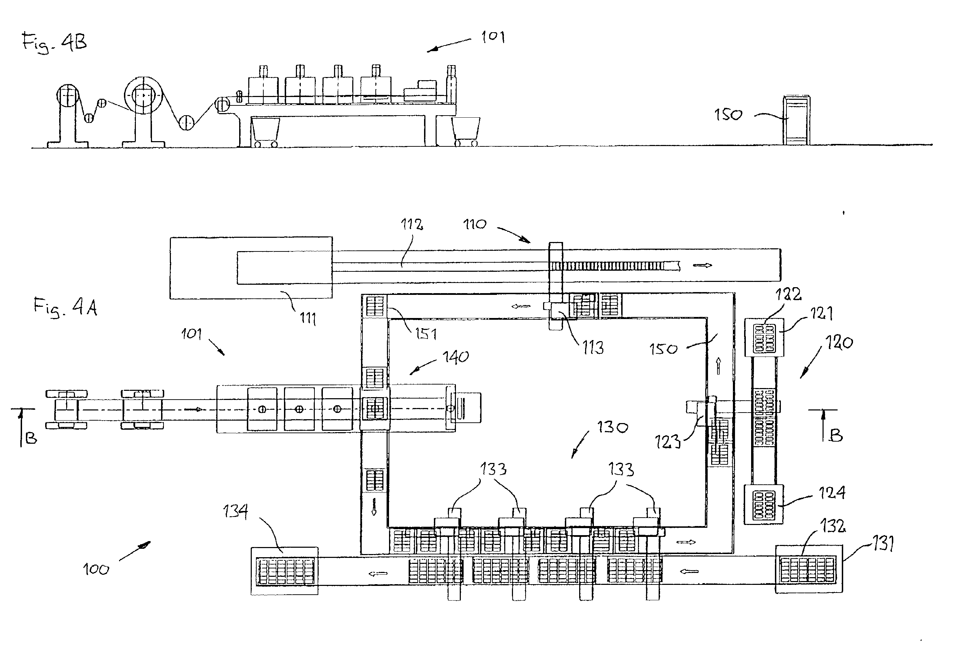

Figs. 4A and 4B show a manufacturing line 100 for bending and subsequent placing or mounting of gasket members, comprising a four-sided general type conveyer line 150 of the same type as in figs. 3A and 3B, however, a number of different facilities are provided which in the figure for illustrative purposes are all in operation, however, normally only single facility is used for a given production run. On the conveyer line a number of fixtures 151 are transported of which only some are shown.

For the initial bending and cutting procedures the assembly line 100 may comprise feeding, bending and cutting means 101 of the same type as described with respect to figs. 3A and 3B.

The manufacturing line 100 comprises a SMD tape-mounting facility 110, a facility 120 in which gaskets are placed in individual fixtures, and a facility 130 in which gaskets are mounted on shields as described above with reference to fig. 2. All three facilities are operated in combination with the gasket placing station 140 which as described above actually places the finished gasket members onto a given member, which as described may be an intermediate transport fixture bringing the gaskets to the desired facility, such as the SMD tape-mounting facility 110, the fixture facility 120, or the shield-mounting facility 130.

The SMD tape-mounting facility comprises a tape-dispenser 111 for supplying a tape 112 onto which gaskets are placed by a robot 113. The fixture facility 120 comprises a means 121 for supplying empty fixtures 122 into which a robot 123 places gaskets where after the filled fixtures are placed in a stack 124. The shield-mounting facility 130 comprises a means 131 for supplying fixtures 132 with shield components onto which gaskets are mounted by a number of robot 133 where after the fixtures with the mounted shields are placed in a stack 134.

As described above, it would also be possible to use the station 140 for mounting the gaskets directly on, for example, the shields when carried by the conveyer line 150.

While the present invention has been described in connection with the preferred embodiment shown in the various figures, it is to be understood that other similar embodiments may be used or modifications and additions may be made to the described embodiment for performing the same function of the present invention without deviating there from. Many other components than metal gasket could be provided for subsequent mounting on any given member.

Any convenient procedure and means for bending the extensions could be used in the context of the present invention, for example a method in which at least one projecting element on the base member is bend without the use of initial clamping means, and where the at least one projecting element has a reduced thickness relative to the member. Such a method is described in Applicants co-pending application, which is hereby incorporated by reference, the application disclosing a method for bending at least one extension projecting from a base member, the method comprising the step of: providing a blank comprising a base member having at least one extension projecting from the base member in a general plane of the base member, the base member and the extension both having a first surface and an opposite second surface, the extension having a reduced thickness relative to the portion of the base member to which it is attached; providing a bending tool comprising a first and a second tool portion, the tool portions comprising, when arranged in register with each other and the blank, at least one projection on one of the tool portions and a corresponding recess in the other tool portion into which the projection can be advanced; placing the blank in register between the two tool portions in such a way that the at least one extension member is arranged between the corresponding recess and projection; advancing the two tool portions toward each other until the first surface of the extension is in contact with the corresponding projection and the opposed second surface of the base member is in contact with an area just outside the corresponding recess, the first surface of the base member being free; further advancing the two tool portions toward each, the projection forcing the extension into the recess thereby providing a plastic deformation substantially corresponding to the attachment of the extension to the base member, wherein the free first surface of the base member remains free during the initial or the entire movement of the extension into the recess; taking the two tool portions away from each and removing the processed blank comprising the bend at least one extension.

Therefore, the present invention should not be limited to any single embodiment, but rather construed in accordance with the appended claims.

## Claims

1. A method for providing a member comprising at least one bend extension projecting from a base member, the method comprising the step of:
- providing at least one sheet-like member comprising at least one blank, the blank comprising a base member with at least one extension projecting in the plane of the base member,
- packing the at least one sheet-like member,
- transporting the packed sheet-like member(s) from a first destination to a second destination,
- providing a bending means (20),
- unpacking at least a portion (3) of the at least one sheet-like member comprising at least one blank,
- introducing a blank into the bending means,
- bending at least one extension projecting from the base of the blank in order to provide a processed blank.

2. A method for providing a member comprising a plurality of bend extensions projecting from a base member, the method comprising the step of:
- providing a continuous length of a sheet-like member comprising a plurality of blanks, each blank comprising a base member with a plurality of extensions projecting in the plane of the base member,
- winding the sheet-like member into a coil (1),
- transporting the coil from a first destination to a second destination,
- providing a bending means (20),
- uncoiling at least a portion (3) of the sheet-like member from the coil comprising at least one blank,
- introducing a blank into the bending means,
- bending at least one extension projecting from the base of the blank in order to provide a processed blank.

3. A method as defined in any of the previous claims, wherein the blanks are connected to each other by connecting bridges, and wherein cutting means are associated with the bending means, the cutting means cutting at least some of the bridges, such that either individual processed blanks or biscuits comprising a number of processed blanks interconnected by bridge portions are provided.

4. A method as defined in any of the previous claims, wherein the sheet-like member (3) is introduced into the bending and/or cutting means.

5. A method as defined in any of the previous claims, further comprising the steps of providing a first conveying means (50) and placing the processed blank(s) thereon.

6. A method as defined in claim 5, wherein a carrier (31), preferably a fixture-like member, is conveyed on the conveying means, the processed blanks being placed on the carrier.

7. A method as defined in claim 6, further comprising the steps of providing a second conveying means (70) conveying a second carrier 32), and transferring the processed blank(s) from the first to the second carrier.

8. A method as defined in any of the previous claims, wherein the step of transporting comprises shipping the packed sheet-like member(s) from a first destination to a second destination, the second destination being external with respect to the first destination.

9. A method as defined in any of the previous claims, wherein the step of packing comprises placing the sheet-like member in an enclosure.

10. A system for providing a member comprising at least one bend extension projecting from a base member, the system comprising:
- means (2) for supporting a packed length of a sheet-like member comprising a plurality of blanks, each blank comprising a base member with a plurality of extensions projecting in the plane of the base member,
- means for unpacking at least a portion (30) of the sheet-like member,
- means (20) for bending at least one extension projecting from the base of the blank in order to provide a processed blank, and
- means for introducing the blank into the bending means.

11. A system for providing a member comprising at least one bend extension projecting from a base member, the system comprising:
- means (2) for supporting a continuous length of a sheet-like member supplied in a coil (1) and comprising a plurality of blanks, each blank comprising a base member with a plurality of extensions projecting in the plane of the base member,
- means for uncoiling at least a portion of the sheet-like member from the coil,
- means (20) for bending at least one extension projecting from the base of a blank in order to provide a processed blank, and
- means (23) for introducing the sheet-like member comprising the blank into the bending means.

12. A system as defined in claim 10 or 11, further comprising cutting means associated with the bending means, the cutting means being adapted to cut at least some of a number of bridges connecting the blanks to each other, such that either individual processed blanks or biscuits comprising a number of processed blanks interconnected by bridge portions are provided.

13. A system as defined in any of claims 10-12, further comprising a placing means (40), a first conveying means (50) whereon the processed blank(s) can be placed by the placing means, the conveying means comprising a carrier (31) adapted to receive the processed blank(s).

14. A system as defined in claim 13, further comprising a second conveying means (70) conveying a second carrier 32), and means for transferring the processed blank(s) from the first to the second carrier.
